# EUROPEAN PATENT APPLICATION

(11) **EP 2 093 804 A1**
(43) Date of publication of application: **26.08.2009**
(21) Application number: 08101766.7
(22) Date of filing: 19.02.2008
(51) Int. Cl.: H01L 31/048

(54) **Solar cell system with encapsulant**

(71) Applicant: Helianthos B.V., 6824 BM Arnhem (NL)
(72) Inventor: Sportel, Edwin Peter, 6846 CE, Arnhem (NL); Scheerder, Willem Jacob, 6861 HJ, Arnhem (NL)
(74) Representative: Hesselink, Dinah Elisabeth

(57) **Abstract**

The present invention is directed to a solar cell system comprising a solar cell the light-receiving surface of which is provided with a transparent encapsulant foil comprising a reinforcing layer and two barrier layers, wherein the first barrier layer is positioned above the reinforcing layer and the second barrier is positioned below the reinforcing layer, determined from the light-receiving side of the solar cell system.

The encapsulant foil itself, a process for manufacture thereof, and a process for manufacturing the solar cell system are also claimed.

## Description

The present invention pertains to a solar cell system provided with an encapsulant layer, and to a method for manufacturing thereof. The present invention also pertains to a transparent multilayer foil suitable as encapsulant foil for solar cells, and to a method for manufacturing thereof.

Thin film solar cells, also known as thin film photovoltaic cells, generally comprise a carrier and a photovoltaic (PV) layer composed of a semiconductor material provided between a front electrode comprising a transparent conductive oxide (TCO) (on the light-receiving side of the cell) and a back electrode (at the back of the cell). The front electrode is transparent, enabling incident light to reach the semiconductor material, where the incident radiation is converted into electric energy. In this way light can be used to generate electric current, which offers an interesting alternative to, say, fossil fuels or nuclear power.

To improve the resistance of solar cells to the environmental conditions to which they are exposed, they are often provided with a protective layer.

US 5,474,620 describes an encapsulant for solar cells which comprises a repeating stack of glass-fiber layers and layers of a thermoplastic material, the whole being topped off with a F-polymer barrier layer.

US 6,331,673 describes a solar cell encapsulant comprising non-woven glass fiber members, a polymer filler, and a protective film. The bottom side of the solar cell foil is also provided with a filler and an insulation film.

US 5,650,019 describes a photovoltaic element encapsulated in a filler layer, which is covered by a hard resin layer, an adhesive layer, and a barrier layer.

US 2006/0207646 describes the use of a cured liquid silicone in the encapsulation of solar cell modules.

The solar cell systems provided with the encapsulant layer as described in the references cited above still suffer disadvantages. More in particular, there is room for improving the long term resistance of the encapsulant layers against damaging. There is therefore a need for a solar cell provided with an encapsulant foil which shows increased long term resistance against damaging and against the long term influence of environmental conditions.

The present invention provides such a solar cell system. The solar cell system according to the invention comprises a solar cell (1), on the light-receiving side of which a transparent encapsulant foil (2) is present, which comprises a reinforcing layer (3) and two barrier layers, wherein the first barrier layer (4) is positioned above the reinforcing layer and the second barrier layer (5) is positioned below the reinforcing layer, determined from the light-receiving side of the solar cell system.

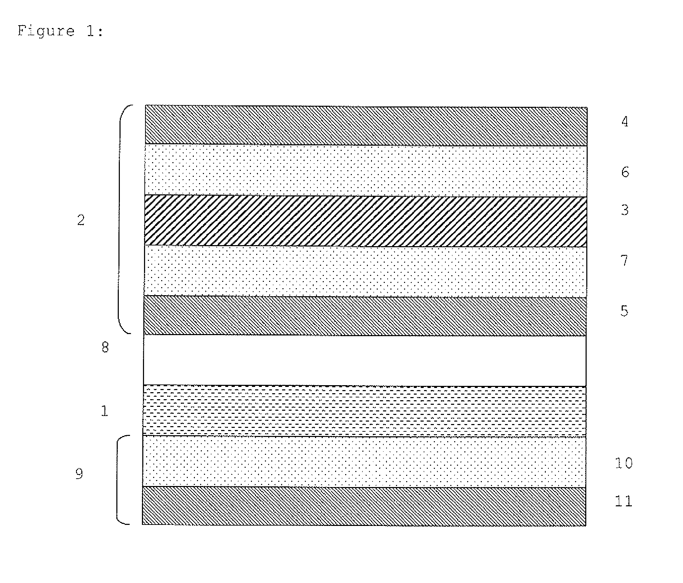

Figure 1 illustrates one embodiment of the present invention. The present invention should not be considered limited thereto or thereby. In this figure, (1) refers to the thin film solar cell, which comprises a TCO layer, a PV layer, a back electrode layer, and optional other components, e.g., a carrier (all not illustrated). (2) refers to the transparent encapsulant foil. (3) refers to the reinforcing layer in the encapsulant foil; (4) refers to the first barrier layer of the encapsulant foil, which is positioned above the reinforcing layer, determined from the light-receiving side of the solar cell system. (5) refers to the second barrier layer of the encapsulant foil, which is positioned below the reinforcing layer, determined from the light-receiving side of the solar cell system. (6) refers to the (optional) intermediate layer present between the first barrier layer and the reinforcing layer. (7) refers to the (optional) intermediate layer present between the second barrier layer and the reinforcing layer. (8) refers to the (optional) adhesive layer, which is intended to adhere the transparent encapsulant foil (2) to the solar cell (1). (9) refers to the (optional) protective foil on the back of the solar cell system, which, in the illustrated embodiment is made up of an intermediate layer (10) and a barrier layer (11).

The solar cell system of the present invention has an increased long-tem resistance against damaging and against the long-term influence of environmental conditions. This is due to the presence of a barrier layer both above and below the reinforcing layer. In the prior art systems, which comprise a barrier above a reinforcing layer, the barrier layer is present to protect the system from environmental conditions, e.g., the entrance of water. The reinforcing layer is intended to protect the underlying solar cell against damages caused by impacting objects, e.g., hailstones or other impacting objects. In the prior art system, an impacting object will be stopped from damaging the solar cell by the reinforcing layer. However, the barrier layer is by then already damaged, and this leaves the system open for the ingress of environmental substances such as water. In contrast, in the system of the present invention, when an impacting object has damaged the first barrier layer and is stopped by the reinforcing layer, the second barrier layer is still intact, and protects the solar cell from environmental substances.

Further, the presence of a transparent encapsulant foil which comprises a reinforcing layer increases the mechanical stability and total strength of the product. Additionally, it will decrease the mechanical load on the solar cell itself. In particular, when the solar cell system is flexible, the presence of a transparent encapsulant foil which comprises a reinforcing layer will help to improve the bending properties of the foil by bringing the force carrier capacity on both sides of the solar cell more in balance. This will improve the strength and flexibility properties of the product for production, storage, transport and installation.

Other advantages of the present invention and of particular embodiments thereof will become apparent from the following specification.

Obviously, the encapsulant foil used in the present invention needs to be transparent. Within the context of the present invention the word transparent means at least transparent for light of the wavelength used by the photovoltaic layer to generate electricity. The transparency of the encapsulant foil, and any other layers which are between the solar cell and the light source, is selected such that at least 50% of the light with this wavelength which falls onto the solar cell system reaches the photovoltaic layer in the solar cell, preferably at least 70%, more preferably at least 80%.

The reinforcing layer used in the encapsulant foil of the present invention may be any layer which increases the resistance of the solar cell system against the impact of external objects. Obviously, the transparency of the layer should be such that the final encapsulant foil is transparent. In a preferred embodiment the reinforcing layer will also contribute to the mechanical stability of the solar cell system, without necessarily detracting from the flexibility of the system in the case that the solar cell itself is flexible.

Suitable reinforcing layers include polymer films, e.g. polymer films reinforced with particulate inorganic materials such as silicon. Suitable reinforcing layers also include layers comprising pulp or fibers of polymer or glass. The fibers may be present in woven or non-woven arrangement. The use of a layer comprising glass fibers, in particular a layer comprising glass fibers in woven or non-woven arrangement is considered preferred because of the suitable physical and chemical properties, transparency, and relatively low cost associated with the use of glass. A specific advantage of using a reinforcing layer comprising glass fibers is as follows. The low thermal expansion and high strength of glass reinforcing material as compared to the polymer components of the encapsulant foil causes a reduction of the total thermal expansion of the solar cell. This is advantageous, because the thermal expansion of the solar cell itself is much lower than that of polymer material. A reduction of the thermal strain difference between the highly inelastic and fragile solar cell itself and the average expansion of the solar cell system significantly reduces the mechanical load change on the solar cell itself during temperature changes. This results in a reduction in failure behaviour from fatigue and increases the reliability and lifetime of the solar cell system.

The thickness of the reinforcing layer is generally at least 8 microns, more in particular at least 20 microns, still more in particular at least 30 microns. The thickness of the reinforcing layer is generally at most 500 microns, more in particular at most 200 microns, still more in particular at most 100 microns.

The barrier layers used in the present invention may be the same or different. They are intended to protect the solar cell from the effect of environmental conditions, in particular from the ingress of water. Further, they should be electrically insulating, anti-soiling and have adequate resistance to degradation under the conditions prevailing during use of the solar cell, and have sufficient integrity to seal and protect the underlying layers. Obviously, their transparency should be such that the final encapsulant foil has the required transparency.
In principle, any polymeric material which meets the above requirements is suitable for use in the present invention. It is within the scope of the person skilled in the art to select a suitable polymer. The following is given as guideline only. Suitable polymers include polyesters such as polyethylene terephthalate (PET) or polyethylene naphthenate (PEN), polycarbonates, polymethyl methacrylate, polyimide, polyphenylene sulphide and fluoropolymers.

One particularly attractive group of polymeric materials are the fluoropolymers, in particular when the solar cell system is intended for long term outdoor use. These materials are transparent, highly inert, strong, and resistant to soiling. Suitable fluoropolymers are commercially available and include copolymers of ethylene and tetrafluoroethylene (ETFE), polytetrafluoroethylene (PTFE), polyvinylidene fluoride (PVDF), fluorinated ethylene propylene copolymers (FEP), tetrafluoroethylene-hexafluoropropylene-vinylidene fluoride terpolymers (THV), tetrafluoroethylene based perfluorinated polymers using monomers such as hexafluoropropene (HFP), perfluoroalkoxyethylene (PFA) and perfluoromethylvinylether and EFEP (a transparent terpolymer, consisting of ethylene, tetrafluoroethylene (TFE) and hexafluoropropylene (HFP))
The barrier layers generally have a thickness of at least 10 microns, more in particular a thickness of at least 17 microns, still more in particular of at least 25 microns. The thickness of the barrier layers is generally at most 500 microns, more in particular at most 200 microns, still more in particular at most 100 microns.
The presence of barrier layers has an additional advantage, namely the protection of the fragile layers of the solar cell from the stiff reinforcing layer. The reinforcing layer distributes a load over the large area which reduces the local stress perpendicular to the surface of the solar cell. This leads to a reduction of the risk of local failure of the solar cell. However, if the reinforcing layer is damaged locally, the second barrier layer between the reinforcing layer and the solar cell serves not only as a chemical barrier but also as a mechanical barrier by elastically absorbing the energy of the stiff sharp point load of broken reinforcing material.

In a preferred embodiment of the present invention, the encapsulant foil additionally comprises an intermediate layer (6) between the reinforcing layer and the first barrier layer, or an intermediate layer (7) between the reinforcing layer and the second barrier layer. In a particularly preferred embodiment intermediate layers (6) and (7) are both present. The purpose of the intermediate layer or layers is to increase the integrity of the encapsulant foil by increasing the adherence of the layers to each other.
The intermediate layer may be made up of any polymer material which is able to fulfil the above requirements. It is within the scope of the skilled person to select a suitable material. It may comprise a thermoplastic or thermosetting polymer. Suitable polymers are known in the art and comprise, for example, ethylene vinyl acetate (EVA), silicone polymers, thermoplastic polyurethanes, polyurethane rubbers (PUR), and polyvinyl butyral(PVB).
It has been found that the use of silicone polymers is particularly attractive in the present invention due to, int. al., their high UV stability, their low processing temperature, the fact that they show now yellowing when subjected to UV radiation, and their high impermeability to water. Of the silicone polymers, both thermoplastic, that is, non-curable, and thermosetting, that is, curable polymers may be used. The use of curable silicone polymer may be preferred, int. al., because they enable the use of a particularly attractive manufacturing process for the encapsulant foil, as will be discussed in more detail below.
In one embodiment of the invention a silicone polymer intermediate layer is combined with a glass fiber reinforcing layer. This combination shows high transparency in combination with good properties.

The intermediate layers, which may be the same or different, generally have a thickness of at least 3 microns, more in particular a thickness of at least 5 microns, still more in particular of at least 8 microns. The thickness of the intermediate layers is generally at most 100 microns, more in particular at most 60 microns, still more in particular at most 40 microns.

The total thickness of the encapsulant foil in the present invention generally is at least 40 microns, more in particularly at least 50 microns, more in particular at least 70 microns. The total thickness of the encapsulant foil in the present invention generally is at most 1700 microns, more in particularly at most 1200 microns, more in particular at most 800 microns. Embodiments with a thickness of at most 400 microns or at most 300 microns may also be envisaged, and sometimes preferred.

It is noted that, as indicated above, the crux of the present invention is that the encapsulant foil encompasses a reinforcing layer and a barrier layer above the reinforcing layer and a barrier layer below the reinforcing layer, determined from the light-receiving side of the solar cell unit. It is within the scope of the present invention to have two or more reinforcing layers present between the barrier layers, if so desired combined with one, two, or more intermediate layers. It is further possible in principle to have a further reinforcing layer present below the second barrier layer. However, this is generally not required.

In the present invention the encapsulant foil is present above the light-receiving side of a solar cell. In a preferred embodiment the encapsulant foil is adhered to the light-receiving side of the solar cell using an adhesive (see adhesive layer (2) in Figure 1). The adhesive may be any transparent adhesive which is capable of adhering the solar cell system to the encapsulant foil. The adhesive should be durable, and able to withstand environmental influences. Suitable adhesives include thermosetting and thermoplastic adhesives. Suitable adhesives include polyurethane rubber, in particular aliphatic polyurethane rubber, silicones, ethylene vinyl acetate (EVA), and polyvinyl butyral (PVB).

In one embodiment the adhesive is a silicone based adhesive. These materials have been found to be transparent, colorless, inert, durable, and able to withstand the conditions prevailing during use of the solar cell system. The use of a curable adhesive has been found to be particularly attractive, int. al., because, as will be elucidated below, it allows the easy manufacture of the system according to the invention.

In general, the adhesive layer has a thickness of at least 2 microns, more in particular a thickness of at least 5 microns. In some cases, the surface of the solar cell may not be completely flat, due to, for example, the presence of a series connection, of busbars, or of other components. If this is the case it may be attractive for the adhesive layer to be thick enough to even out the difference in height. In that case, the adhesive layer may have a thickness of at least 50 microns, more in particular at least 100 microns, in some cases at least 125 microns, depending on the thickness of the components to be encapsulated.
The maximum thickness of the adhesive layer is not critical to the present invention and could be as thick as up to 500 microns, while values up to 200 microns would be more conventional.

The nature of the solar cell that is combined with the encapsulant foil in the present invention is not critical. They will generally comprise a back electrode, a photovoltaic layer, and most often a transparent front electrode based on a transparent conductive oxide, often indicated as TCO layer. Other conventional elements of solar cells may also be present such as barrier layers, series connections, bus bars, carrier layers below the back electrode, protective layers above the TCO, etc. The various components of solar cells are known in the art and require no further elucidation here.
A type of solar cell to which the present invention is of particular use are the solar cells where the photovoltaic layer, or where present the TCO layer, is not covered with a transparent over layer, e.g., a transparent glass plate or the like. Solar cells which are particularly suitable for use in the present invention are flexible solar cell foils comprising, from the light-incident side down, a TCO layer, a PV layer, a back electrode layer, and a flexible substrate. Suitable solar cell foils are described, for example in WO98/13882, WO99/49483, WO01/47020, WO01/78156, WO03/001602, WO03/075351, and WO2005/015638 the disclosures of which as regards the nature of the various components of the solar cells are incorporated herein by reference.
The application of a flexible solar cell foil in the present invention is so attractive because the present invention allows the encapsulation of such a solar cell system while maintaining its flexibility.

In one embodiment of the present invention a flexible solar cell foil comprising from the light-receiving side down a TCO layer, a photovoltaic layer, a back electrode layer, and a flexible substrate is encapsulated with an encapsulant foil as discussed above on the light-receiving side of the solar cell foil, and with a protective foil on the non-light-receiving side of the solar cell. In one embodiment, the protective foil comprises comprising an intermediate layer and a barrier layer. In another embodiment the protective foil comprises a reinforcing layer and two barrier layers, wherein the first barrier layer is positioned on one side of the reinforcing layer and the other is positioned on the other side of the reinforcing layer. In this embodiment the protective foil may be an encapsulant foil as described in detail above, including, if so desired intermediate layers.
For the properties of the layers reference is made to what has been discussed above.
The protective foil may be combined with the solar cell system using an adhesive layer, e.g., as specified above.

In general it is noted that the transparent encapsulant foil described above may also be suitable for application on the non-light receiving side of a solar cell, for providing protection thereto. The protective foil may be combined with the solar cell system using an adhesive layer, e.g., as specified above.

In one embodiment, the encapsulant foil suitable for use in the solar cell system according to the invention can be manufactured as follows. The reinforcing layer is sandwiched between two barrier layer foils, and the combination is subjected to a pressure step to adhere the layers to each other. The presence of an adhesive intermediate layer is however preferred.
Where intermediate layers are present between the barrier layers and the reinforcing layers, the process may, in one embodiment, be carried out as follows. In a first step, the polymer that will provide the intermediate layer is applied onto a foil of the barrier layer, either by a lamination process where the intermediate layer polymer is already in the form of a foil, or by an appropriate spreading process where the polymer is in liquid form. The reinforcing layer is applied onto the polymer, and the layer set is combined with the second barrier layer which has previously been provided with the polymer that will provide the intermediate layer. Where the intermediate layer is curable, the total layer set is then subjected to a curing step to cure the intermediate layer polymer. In a preferred embodiment, the foil is manufactured via a roll-to-roll process.

The encapsulant foil may be combined with the solar cell by a lamination process. If an adhesive layer is present, either the solar cell or the encapsulant foil, or both, are covered with the adhesive, and the encapsulant foil is adhered to the solar cell. Where the adhesive needs to be cured, a curing step is carried out. Where the solar cell is a flexible solar cell foil, this process can, in a preferred embodiment, be carried out in the form of a roll-to-roll process.

The flexibility of a solar cell foil, before and after encapsulation, may be expressed by the curvature (defined as the inverse bending radius [1/m]). A curvature of null m-1 represents a perfectly flat laminate. The positive and negative curvature represent bending the solar cell laminate with the light receiving side on the outside and inside, respectively.
For flexible solar cell systems according to the invention it is preferred that after encapsulation the maximum curvature, defined as the inverse bending ratio above which the solar cell breaks down, is at least 2 m-1, more preferably at least 10 m-1, still more preferably at least 40 m-1. In some cases a maximum curvature of at least 100 m-1 may be obtained. It is a surprising feature of the present invention that the maximum curvature of the solar cell system may be higher than that of the solar cell itself. This is because the presence of the encapsulation layer reduces the stress on the solar cell during bending.

As indicated above, in this embodiment it may be attractive to apply a back encapsulant layer comprising an intermediate layer and a barrier layer. The application of the back encapsulant can be integrated in the above process.

When used in a solar cell foil the cured encapsulant layer is combined with a solar cell foil, while on the other side of the solar cell foil a foil comprising a barrier layer and an intermediate layer may be applied.

## Claims

1. A solar cell system comprising a solar cell on the light-receiving side of which a transparent encapsulant foil is present which comprises a reinforcing layer and two barrier layers, wherein the first barrier layer is positioned above the reinforcing layer and the second barrier is positioned below the reinforcing layer, determined from the light-receiving side of the solar cell system.

2. Solar cell system according to claim 1 wherein an adhesive layer is present between the solar cell and the encapsulant foil.

3. Solar cell system according to any one of the preceding claims wherein at least one of the barrier layers is a layer of a fluoropolymer.

4. Solar cell system according to any one of the preceding claims wherein the reinforcing layer comprises glass fibers, in woven or non-woven form.

5. Solar cell system according to any one of the preceding claims wherein in the encapsulant foil an intermediate layer is present between the reinforcing layer and the first barrier layer, between the reinforcing layer and the second barrier layer, or between the reinforcing layer and both the first and second barrier layers.

6. Solar cell system according to claim 5 wherein the intermediate layer is a silicone polymer layer.

7. Process for manufacturing a solar cell system according to any one of claims 1-6 wherein a transparent encapsulant foil which comprises a reinforcing layer and two barrier layers, wherein the first barrier layer is positioned above the reinforcing layer and the second barrier is positioned below the reinforcing layer, is applied on the light-receiving side of a solar cell.

8. Process according to claim 7 wherein a back encapsulant layer is applied to the non-light receiving side of the solar cell, before, after, or simultaneous with the application of the encapsulant foil.

9. Transparent encapsulant foil suitable for the encapsulation of solar cell which comprises sequentially a first barrier layer, a first intermediate layer, a reinforcing layer, a second intermediate layer, and a second barrier layer.

10. Process for manufacturing a transparent encapsulant foil according to claim 9, which comprises the steps of providing the polymer that will provide the intermediate layer onto a foil of the barrier layer, either by a lamination process where the intermediate layer polymer is already in the form of a foil, or by an appropriate spreading process where the polymer is in liquid form, applying the reinforcing layer onto said polymer, combining the layer set with the second barrier layer which has previously been provided with the polymer that will provide the intermediate layer, and, where the intermediate layer is curable, subjecting the total layer set to a curing step to cure the intermediate layer polymer.
